# FASCICULE DE BREVET EUROPEEN

(11) **EP 3 168 924 B1**
(45) Date de publication et mention de la délivrance du brevet: **29.01.2020**
(21) Numéro de dépôt: 16198997.5
(22) Date de dépôt: 15.11.2016
(51) Int. Cl.: H01M 10/48, H01M 10/42, G01R 31/378, G01R 31/36, H01M 10/30

(54) **BATTERIE NI-CD MUNIE D'UN INDICATEUR D' ÉTAT DE CHARGE**
NI-CD-BATTERIE, DIE MIT EINER LADUNGSZUSTANDSANZEIGE AUSGESTATTET IST
NI-CD BATTERY WITH A STATE-OF-CHARGE INDICATOR

(30) Priorité: 16.11.2015 FR 1560994
(43) Date de publication de la demande: 17.05.2017
(73) Titulaire: SAFT, 93170 Bagnolet (FR)
(72) Inventeur: GIRARD, Kévin, 33290 BLANQUEFORT (FR); TEXIER, Jean-Pierre, 33160 SAINT AUBIN DE MEDOC (FR); LACOMBE, Dominique, 64480 LARRESSORE (FR); TRIDON, Xavier, 33000 BORDEAUX (FR); LAVAUR, Pascal, 17150 SAINT DIZANT DU BOIS (FR)
(74) Mandataire: Hirsch & Associés

(56) Documents cités:
- EP-A1- 0 225 106
- EP-A1- 2 317 598
- EP-A1- 2 924 454
- DE-A1- 10 056 972
- DE-U1- 29 724 016
- US-A1- 2002 193 955
- US-A1- 2015 042 285

## Description

### DOMAINE TECHNIQUE

Le domaine technique de la présente invention est celui des batteries d'accumulateurs électrochimiques au nickel-cadmium, appelées batteries Ni-Cd. Plus particulièrement, la présente invention concerne une batterie Ni-Cd munie d'un indicateur de son état de charge.

Une batterie Ni-Cd qui fonctionne dans un mode de repos, c'est-à-dire qui n'est ni dans un mode de charge ni dans un mode de décharge, a une tension proche de 1,2 volts par élément quel que soit son état de charge.

Il est donc impossible, pour un utilisateur d'une batterie de ce type qui ne mesure que sa tension, de connaître sa capacité électrique réellement disponible et donc si elle est utilisable ou non.

### ÉTAT DE LA TECHNIQUE

Dans l'état de la technique, pour évaluer la capacité électrique théoriquement disponible d'une batterie Ni-Cd, on connaît l'enseignement du document US4949046A qui divulgue un indicateur du taux de charge d'une telle batterie.

Dans ce document, le taux de charge est estimé en fonction de mesures de la tension, de l'intensité et de la température de la batterie.

Puisque la capacité d'une batterie diminue avec le temps, ces mesures sont réalisées à chaque fois que ladite batterie est complètement chargée et à chaque fois qu'elle est complètement déchargée.

Mais, de fait, cet indicateur ne tient pas compte de l'évolution de la tension, de l'intensité et de la température de la batterie entre deux mesures et ne propose pas de recalage en fin de charge.

Ainsi, cet indicateur ne peut notamment ni tenir compte de l'auto-décharge qu'une batterie subit lorsqu'elle est dans un mode de repos à circuit ouvert, ni de ses conditions de charge/décharge.

Par conséquent le taux de charge déterminé par cet indicateur n'est pas précis et ne révèle donc pas la capacité réellement disponible de la batterie sur laquelle il est disposé.

Cette imprécision peut s'avérer dangereuse, en particulier lorsqu'elle concerne une batterie de secours, destinée à fournir une quantité d'énergie minimale indispensable à la sécurité des utilisateurs. Les documents EP2317598, DE10056972, EP225106 et DE29724016U1 décrivent des indicateurs d'état de charge de batteries.

Il existe donc un réel besoin de réaliser un indicateur précis et fiable de l'état de charge d'une batterie Ni-Cd.

### RÉSUMÉ DE L'INVENTION

A cette fin, la présente invention propose une batterie d'accumulateurs électrochimiques au nickel-cadmium comportant un indicateur de son état de charge, ledit indicateur comprenant
- des capteurs pour réaliser des mesures continues de tension et d'intensité du courant électrique et de température de ladite batterie,
- des moyens de détermination à un instant t, d'un historique de charge/décharge de ladite batterie en fonction desdites mesures,
- des moyens de stockage de données dans lesquels sont mémorisés au moins un historique de charge/décharge, une tension, une intensité et une température de référence prédéfinis, ainsi que lesdites mesures et l'historique déterminé,
- une unité de contrôle destinée à
   - mesurer une tension, une intensité et une température de ladite batterie à l'instant t,
   - déterminer un mode de fonctionnement de ladite batterie par comparaison de la tension et de l'intensité mesurées à l'instant t, vis-à-vis de la tension et de l'intensité de référence, respectivement,
   - déterminer une correction de la tension et de l'intensité mesurées à l'instant t par comparaison de la température mesurée à l'instant t, vis-à-vis de la température de référence,
   - calculer une capacité théoriquement disponible de ladite batterie en fonction du mode de fonctionnement et de ladite correction,
   - déterminer un besoin de recalage de la capacité théoriquement disponible de la batterie par comparaison de l'historique déterminé à l'instant t vis-à-vis de l'historique de référence,
   - en fonction dudit besoin de recalage et de ladite capacité théoriquement disponible, calculer une capacité réellement disponible de ladite batterie,
   - en fonction de ladite capacité réellement disponible, définir l'état de charge de ladite batterie,
- un dispositif d'affichage dudit état de charge défini.

Grâce à ces dispositions, l'indicateur selon l'invention surveille en permanence la batterie sur laquelle il est disposé et détermine ainsi, de façon précise, la capacité réellement disponible de ladite batterie à afficher.

Selon des caractéristiques particulières de cette batterie, l'indicateur d'état de charge de ladite batterie est destiné à détecter une fin de charge de ladite batterie en fonction de l'historique déterminé de ladite batterie, la détermination de la capacité théoriquement disponible de ladite batterie étant réalisée après ladite détection de fin de charge.

Grâce à ces dispositions, un utilisateur de la batterie peut déterminer si elle peut être utilisée immédiatement ou si elle doit être rechargée ou reconditionnée.

Pour rappel, on entend par reconditionnement d'une batterie un ensemble de séquences de charge/décharge permettant de rééquilibrer les capacités de ses électrodes positives et négatives, ce qui lui permet de recouvrer 100% de sa capacité.

Selon d'autres caractéristiques particulières de cette batterie, l'historique de référence et l'historique déterminé comportent des données relatives
- à une température moyenne de la batterie, et/ou
- à la profondeur d'au moins une précédente décharge de ladite batterie, et/ou
- au temps qu'elle a passé en auto-décharge dans un mode de fonctionnement de repos à circuit ouvert, et/ou
- au nombre de fois où elle a été chargée et/ou déchargée.

Grâce à ces dispositions, la précision de la détermination du besoin de recalage est augmentée.

Selon encore d'autres caractéristiques particulières de cette batterie,
- elle comporte en outre un circuit de remplissage d'eau,
- l'historique de référence et l'historique déterminé comportent des données relatives à sa consommation d'eau.

Grâce à ces dispositions, la précision de la détermination du besoin de recalage et la définition de l'état de charge de la batterie sont améliorées.

Selon un mode de réalisation préféré de cette batterie, l'indicateur d'état de charge de ladite batterie est en outre destiné à
- calculer un taux de charge absolu de ladite batterie en divisant la capacité réellement disponible par une capacité nominale prédéterminée de ladite batterie,
- définir l'état de charge de ladite batterie comme étant le taux de charge absolu.

Grâce à ces dispositions, un utilisateur de la batterie peut estimer à l'œil nu la capacité réellement disponible de ladite batterie et juger si celle-ci est suffisante ou non pour une utilisation future donnée.

Selon un autre mode de réalisation de cette batterie, l'indicateur d'état de charge de ladite batterie est en outre destiné à
- comparer une capacité minimale nécessaire pour une utilisation future de ladite batterie à la capacité réellement disponible de ladite batterie, ladite capacité minimale étant prédéfinie,
- définir l'état de charge de ladite batterie comme étant
   - suffisant si ladite capacité réellement disponible est strictement supérieure à ladite capacité minimale,
   - insuffisant si ladite capacité réellement disponible est inférieure ou égale à ladite capacité minimale.

Grâce à ces dispositions, un utilisateur de la batterie peut très rapidement savoir s'il peut utiliser ladite batterie ou doit en choisir une autre.

Selon encore un mode de réalisation de cette batterie, l'indicateur d'état de charge de ladite batterie est en outre destiné à
- comparer un seuil prédéfini de capacité réellement disponible de ladite batterie à la capacité réllement disponible de ladite batterie,
- définir l'état de charge de ladite batterie comme étant
   - suffisant si la capacité réellement disponible est strictement supérieur audit seuil,
   - insuffisant si la capacité réellement disponible est inférieure ou égale audit seuil.

Grâce à ces dispositions, un utilisateur de la batterie peut très rapidement savoir s'il peut utiliser ladite batterie ou doit en choisir une autre.

Selon encore un autre mode de réalisation de cette batterie, l'indicateur d'état de charge de ladite batterie est en outre destiné à
- déterminer une profondeur de décharge et un taux de décharge relatif de ladite batterie,
- comparer un seuil de taux de décharge relatif prédéfini de ladite batterie audit taux de décharge relatif,
- définir l'état de charge de ladite batterie comme étant
   - suffisant si le taux de décharge relatif est strictement inférieur audit seuil,
   - insuffisant si le taux de décharge relatif est supérieur ou égal audit seuil.

Grâce à ces dispositions, un utilisateur de la batterie peut très rapidement savoir s'il peut utiliser ladite batterie ou doit en choisir une autre.

Selon encore d'autres caractéristiques particulières de cette batterie, le dispositif d'affichage de l'état de charge est
- soit binaire si ledit état de charge est défini comme étant suffisant ou insuffisant,
- soit gradué si ledit état de charge est défini comme étant un taux de charge absolu.

Les inventeurs ont déterminé que ces dipositions étaient optimales.

Selon encore d'autres caractéristiques particulières de cette batterie,
- les moyens de mesure de l'intensité du courant électrique de ladite batterie comportent un shunt,
- les moyens de mesure de la température de ladite batterie comportent une thermistance de type CTN.

Les inventeurs ont déterminé que ces dipositions étaient optimales.

L'invention a également pour objet un système de gestion comportant
- au moins une batterie selon l'invention,
- un dipositif de contrôle distant de l'état de charge de l'au moins une batterie, l'indicateur d'état de charge de l'au moins une batterie étant connecté, via un dispositif de communication, au dispositif de contrôle.

Grâce à ces dispositions, un utilisateur de ce système peut optimiser la gestion d'un stock de batteries selon l'invention.

L'invention a également pour objet un procédé d'indication d'un état de charge d'une batterie d'accumulateurs électrochimiques au nickel-cadmium selon l'invention, ledit procédé comprenant des étapes de
- mesures continues de tension et d'intensité du courant électrique et de température de ladite batterie,
- détermination à un instant t d'un historique de charge/décharge de ladite batterie en fonction desdites mesures,
- mesure d'une tension, d'une intensité et d'une température de ladite batterie à l'instant t,
- détermination d'un mode de fonctionnement de ladite batterie par comparaison de la tension et de l'intensité mesurées à l'instant t, vis-à-vis de la tension et de l'intensité de référence, respectivement,
- détermination d'une correction de la tension et de l'intensité mesurées à l'instant t par comparaison de la température mesurée à l'instant t, vis-à-vis de la température de référence,
- calcul d'une capacité théoriquement disponible de ladite batterie en fonction du mode de fonctionnement et de ladite correction,
- détermination d'un besoin de recalage de la capacité théoriquement disponible de la batterie par comparaison de l'historique déterminé à l'instant t vis-à-vis de l'historique de référence,
- en fonction dudit besoin de recalage et de ladite capacité théoriquement disponible, calcul d'une capacité réellement disponible de ladite batterie,
- en fonction de ladite capacité réellement disponible de ladite batterie, définition de l'état de charge de ladite batterie,
- affichage dudit état de charge défini.

Les avantages liés à ce procédé, étant similaires à ceux de la batterie selon l'invention, ne sont pas rappelés ici.

### BRÈVE DESCRIPTION DES FIGURES

D'autres caractéristiques et avantages de l'invention apparaîtront à la lecture de la description qui suit de trois modes de réalisation préférés de l'invention, donnés à titre d'exemple et en référence aux figures annexées qui montrent :
- figure 1, un schéma d'un exemple de batterie Ni-Cd selon l'invention ;
- figure 2, une représentation, sous forme d'un logigramme d'un exemple de procédé d'indication d'un état de charge d'une batterie selon l'invention.

Dans la suite de la description, les éléments identiques ou de fonction identique portent le même signe de référence. À fin de concision de la présente description, les éléments identiques aux différents exemples ne sont pas décrits en regard de chacun de ces exemples. En d'autres termes, seules les différences entre les différents exemples sont décrites de manière détaillée, les éléments communs étant décrits en regard d'un seul exemple.

Par ailleurs, dans la suite de la description, les valeurs numériques mentionnées, quoique non limitatives, se sont révélées aux essais comme fournissant les résultats les plus avantageux.

### EXPOSÉ DE MODES DE RÉALISATION

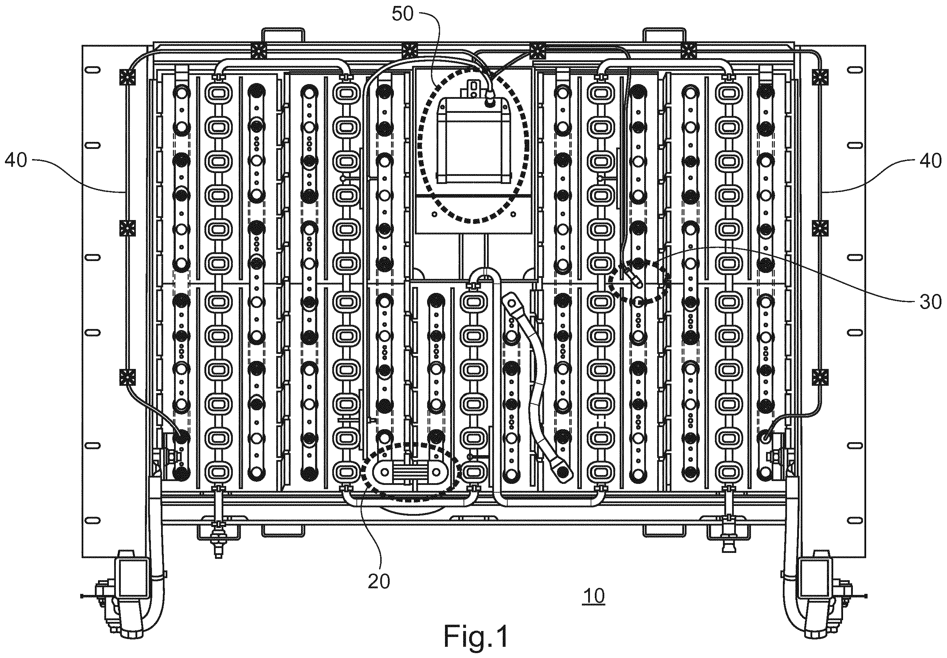

La figure 1 représente un exemple de réalisation d'une batterie 10 selon l'invention.

La batterie 10 comporte des accumulateurs électrochimiques au nickel-cadmium Ni-Cd et un indicateur de son état de charge.

L'invention concerne donc également l'indicateur d'état de charge d'une batterie Ni-Cd selon l'invention.

L'indicateur selon l'invention comprend
- des capteurs 20, 30 et 40 pour réaliser des mesures de tension et d'intensité du courant électrique et de température de la batterie 10,
- des moyens de détermination à un instant t d'un historique H_{T} de charge/décharge de la batterie 10 en fonction desdites mesures,
- des moyens de stockage de données,
- une unité de contrôle,
- un dispositif 50 d'affichage de l'état de charge de la batterie 10.

Dans l'exemple, la batterie 10 comporte en outre un circuit de remplissage d'eau.

Dans un premier exemple, les moyens de stockage et l'unité de contrôle sont matérialisés par un microcontrôleur PIC (Peripheral Interface Controller, en langue anglaise).

Dans un deuxième exemple, les moyens de stockage sont matérialisés par une carte mémoire amovible de stockage, par exemple une carte SD (Secure Digital, en langue anglaise). Typiquement, le dispositif d'affichage 50 de l'état de charge de la batterie 10 est soit binaire si ledit état de charge est défini comme étant suffisant ou insuffisant, soit gradué si ledit état de charge est défini comme étant un taux de charge absolu.

Dans le cas d'un dispositif d'affichage binaire, celui-ci peut par exemple se présenter sous la forme d'un voyant rouge, qui est allumé pour indiquer que l'état de charge de la batterie 10 est insuffisant, et d'un vert qui est allumé pour indiquer que l'état de charge de la batterie 10 est suffisant.

Typiquement, les moyens de mesure 20 de l'intensité I du courant électrique de la batterie 10 comportent un shunt remplaçant une connexion inter-éléments de la batterie 10 et les moyens de mesure 30 de la température de ladite batterie comportent une thermistance, par exemple de type CTN.

Dans un exemple préféré, le shunt utilisé dans l'invention supporte une intensité nominale de 500 ampères, présente une chute de tension de 0,1 volt et une classe de tolérance de résistance de 0,5% de sorte que sa précision est de 0,3 milliampères. Dans le cas d'un shunt à lamelles, il convient de veiller à l'orientation et à l'épaisseur de celles-ci.

Au moins un historique H_{R} de charge/décharge, une tension, une intensité et une température de référence prédéfinis, les mesures de tension et d'intensité du courant électrique et de température et l'historique déterminé, sont mémorisés dans les moyens de stockage de données.

On entend par historique de charge/décharge un ensemble de données définies en fonction de mesures continues de tension, d'intensité et de température de la batterie 10.

De préférence, l'historique de référence H_{R} et l'historique déterminé H_{T} à l'instant t comportent des données relatives à une température moyenne de la batterie 10 et/ou à la profondeur d'au moins une précédente décharge de ladite batterie, et/ou au temps qu'elle a passé en auto-décharge dans un mode de fonctionnement de repos R à circuit ouvert, et/ou au nombre de cycles de charge/décharge qu'elle a effectués.

En outre, l'historique de référence H_{R} et l'historique déterminé H_{T} à l'instant t peuvent comporter des données relatives à un ratio de la capacité chargée par rapport à la capacité déchargée lors du dernier cycle effectué et/ou au cours de l'ensemble des cycles effectués par la batterie 10.

Dans l'exemple, l'historique de référence H_{R} et l'historique déterminé H_{T} à l'instant t comportent en outre des valeurs et un seuil de consommation d'eau de la batterie 10 déterminés en fonction notamment des mesures de température.

L'unité de contrôle est destinée à
- mesurer une tension U_{T}, une intensité I_{T} et une température T_{T} de la batterie 10 à l'instant t,
- déterminer un mode de fonctionnement de charge Ch ou de décharge D ou de repos R de ladite batterie par comparaison de la tension U_{T} et de l'intensité I_{T} mesurées à l'instant t, vis-à-vis de la tension U_{R} et de l'intensité I_{R} de référence, respectivement,
- déterminer une correction de la tension U_{T} et de l'intensité I_{T} mesurées à l'instant t par comparaison de la température T_{T} mesurée à l'instant t, vis-à-vis de la température T_{R} de référence,
- calculer une capacité théoriquement disponible CT_{DISPO} de ladite batterie en fonction du mode de fonctionnement Ch ou D ou R et de ladite correction,
- déterminer un besoin de recalage R_{C} de la capacité théoriquement disponible CT_{DISPO} de la batterie par comparaisonde l'historique H_{T} déterminé à l'instant t vis-à-vis de l'historique de référence H_{R},
   - en fonction dudit besoin de recalage R_{C} et de ladite capacité théoriquement disponible, calculer la capacité réellement disponible CR_{DISPO} de ladite batterie,
   - en fonction de ladite capacité réellement disponible CR_{DISPO}, définir l'état de charge ÉTAT_{CHARGE} de ladite batterie,
- en fonction dudit besoin de recalage et de ladite capacité théoriquement disponible, calculer la capacité réellement disponible de ladite batterie,
- en fonction de cette capacité réellement disponible, définir l'état de charge de ladite batterie.

Pour rappel, la capacité électrique d'une batterie est définie comme étant la charge électrique que ladite batterie peut fournir dans des conditions de décharge spécifiées ; elle peut s'exprimer en Coulombs, en Ampères-secondes ou (en pratique) en Ampères-heures (1 Ah = 3600 As = 3600 C).

Concernant la mesure de la température T_{T}, l'instant t peut en pratique durer une heure environ. Dans ce cas, la valeur de température T_{T} retenue pour la détermination de la correction, c'est-à-dire l'ajustement, à appliquer au courant est sa moyenne pendant cette heure écoulée. Il est important de pondérer les valeurs de capacité électrique des batteries Ni-Cd, en particulier lorsque ces batteries sont en charge.

Typiquement, l'unité de contrôle est de type processeur, microcontrôleur, PLD (programmable logic device, en langue anglaise), FPGA (field-programmable gate array, en langue anglaise), EPLD (erasable programmable logic device, en langue anglaise), CPLD (complex programmable logic device en langue anglaise), PAL (programmable array logic, en langue anglaise), ou PLA (programmable logic array, en langue anglaise).

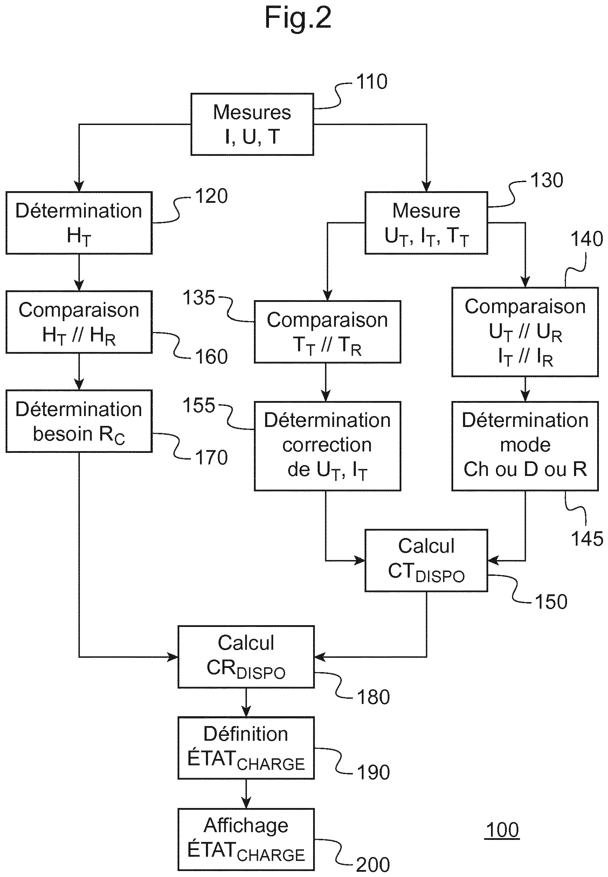

La figure 2 représente, sous forme d'un logigramme, un exemple de procédé 100 d'indication de l'état de charge ÉTAT_{CHARGE} de la batterie 10 selon l'invention.

Le procédé 100 comprend des étapes de
- mesures continues 110 de tension U et d'intensité I du courant électrique et de température T de la batterie 10,
- détermination 120 de l'historique H_{T} de charge/décharge de la batterie 10 à l'instant t en fonction desdites mesures,
- mesure 130 de la tension U_{T}, de l'intensité I_{T} et de la température T_{T} de ladite batterie à l'instant t,
- détermination 145 d'un mode de fonctionnement Ch ou D ou R de ladite batterie par comparaison 140 de la tension U_{T} et de l'intensité I_{T} mesurées à l'instant t, vis-à-vis de la tension U_{R} et de l'intensité I_{R} de référence, respectivement,
- détermination d'une correction de la tension U_{T} et de l'intensité I_{T} mesurées à l'instant t par comparaison de la température T_{T} mesurée à l'instant t, vis-à-vis de la température T_{R} de référence,
- calcul 150 de la capacité théoriquement disponible CT_{DISPO} de ladite batterie en fonction du mode de fonctionnement Ch ou D ou R déterminé et de ladite correction,
- détermination 170 du besoin de recalage R_{C} de la capacité théoriquement disponible CT_{DISPO} de la batterie par comparaison 160 de l'historique H_{T} déterminé à l'instant t vis-à-vis de l'historique de référence H_{R},
- en fonction dudit besoin de recalage R_{C} et de ladite capacité théoriquement disponible, calcul 180 de la capacité réellement disponible CR_{DISPO} de la batterie 10,
- en fonction de ladite capacité réellement disponible CR_{DISPO} de la batterie 10, définition 190 de l'état état de charge ÉTAT_{CHARGE} de la batterie 10,
- affichage 200 dudit état de charge défini.

De préférence, le procédé 100 comprend en outre une étape de détection d'une fin de charge de la batterie 10 en fonction de l'historique déterminé H_{T} de ladite batterie.

De fait, la détermination de la capacité théoriquement disponible CTDISPO de la batterie 10 est réalisée après ladite détection de fin de charge.

De préférence, le procédé 100 comprend en outre des étapes de calcul d'un taux de charge absolu SOC_{ABS} de la batterie 10 en divisant la capacité réellement disponible CR_{DISPO} par une capacité nominale C_{NOM} prédéterminée de ladite batterie, puis de définition de l'état de charge ÉTAT_{CHARGE} de ladite batterie comme étant le taux de charge absolu SOC_{ABS}.

Autrement dit, la capacité nominale C_{NOM} de la batterie 10 est sa capacité réellement disponible lorsqu'elle est neuve.

Dans une première variante, le procédé 100 comprend en outre des étapes de comparaison d'une capacité minimale C_{MIN} nécessaire pour que la batterie 10 assure une mission prédéterminée à la capacité réellement disponible CR_{DISPO} de ladite batterie, ladite capacité minimale étant prédéfinie, puis de définition de l'état de charge ÉTAT_{CHARGE} de ladite batterie comme étant
- suffisant si la capacité réellement disponible CR_{DISPO} est strictement supérieure à la capacité minimale C_{MIN},
- insuffisant si la capacité réellement disponible CR_{DISPO} est inférieure ou égale à la capacité minimale C_{MIN}.

Autrement dit, la capacité minimale C_{MIN} d'une batteire 10 est sa capacité nécessaire pour accomplir correctement sa mission prédéterminée.

Dans une deuxième variante, le procédé 100 comprend en outre des étapes de comparaison d'un seuil C_{SEUIL} prédéfini de capacité réellement disponible de la batterie 100 à la capacité réllement disponible CR_{DISPO} de ladite batterie, puis de définition de l'état de charge ÉTAT_{CHARGE} de ladite batterie comme étant
- suffisant si la capacité réellement disponible CR_{DISPO} est strictement supérieur au seuil C_{SEUIL},
- insuffisant si la capacité réellement disponible CR_{DISPO} est inférieure ou égale audit seuil C_{SEUIL}.

Autrement dit, la capacité Cseuil d'une batterie 10 est sa capacité minimale dans l'absolu, c'est-à-dire sans prendre quelque utilisation future que ce soit.

Dans une troisième variante, le procédé 100 comprend en outre des étapes de détermination d'une profondeur de décharge et d'un taux de décharge relatif SOC_{DÉCHARGE} de la batterie 10, de comparaison d'un seuil de taux de décharge relatif SOC_{SEUIL} prédéfini de ladite batterie audit taux de décharge relatif SOC_{DÉCHARGE}, puis de définition de l'état de charge ÉTAT_{CHARGE} de ladite batterie comme étant
- suffisant si le taux de décharge relatif SOC_{DÉCHARGE} est strictement inférieur au seuil SOC_{SEUIL},
- insuffisant si le taux de décharge relatif SOC_{DÉCHARGE} est supérieur ou égal au seuil SOC_{SEUIL}.

Pour déterminer un mode de fonctionnement de la batterie 10, on compare l'intensité I_{T} de ladite batterie à un seuil d'intensité de charge I_{R} prédéfini, puis
- si ladite intensité I_{T} est supérieure audit seuil d'intensité I_{R}, on considère que la batterie fontionne dans un mode de charge Ch,
- si ladite intensité I_{T} est inférieure audit seuil d'intensité I_{R}, on la compare à un seuil d'intensité de décharge prédéfini.

Si l'intensité I_{T} de la batterie 10 est inférieure au seuil d'intensité de décharge I_{R}, on considère que ladite batterie fontionne dans un mode de décharge D.

Si l'intensité I_{T} de la batterie 10 est supérieure au seuil d'intensité de décharge I_{R}, on compare la tension U_{T} de ladite batterie à un seuil de tension de décharge U_{R}.

Si la tension U_{T} de la batterie 10 est inférieure au seuil de tension de décharge U_{R}, on considère que ladite batterie fontionne dans un mode de repos R.

Si la tension U_{T} de la batterie 10 est supérieure au seuil de tension de décharge U_{R}, on considère que ladite batterie fontionne dans un mode de charge Ch.

L'invention concerne également un système de gestion comportant au moins une, typiquement une pluralité de, batterie(s) 10 et un dipositif de contrôle distant de l'état de charge ÉTAT_{CHARGE} de l'au moins une batterie. L'indicateur d'état de charge de l'au moins une batterie 10 est alors connecté, via un moyen de communication, au dispositif de contrôle distant, par exemple, un serveur réseau d'Internet ou d'Intranet.

De préférence, ce moyen de communication est sans fil et fonctionne par exemple par Wi-Fi (Wireless Fidelity, en langue anglaise), Bluetooth, ou par réseau de télécommunication sans fil (éventuellement un réseau de bas débit de type SIGFOX), etc.

Cette connexion peut également se faire sur tout réseau filaire propre à l'utilisateur, en respectant le protocole de communication dudit réseau.

Ce moyen de communication peut transférer au serveur réseau, de manière autonome, régulière et périodique, un ensemble d'informations mesurées ou calculées, de ladite batterie, pouvant comprendre :
- une tension,
- une intensité ,
- une température,
- un état de charge,
- une consommation d'eau.

Le système de gestion peut également être en mesure de transférer sur le serveur réseau à un moment précis, une alerte à l'utilisateur, sur détection de l'atteinte d'un seuil prédéfini, par exemple, un seuil de tension, d'intensité, d'état de charge, de consommation d'eau ou sur détection d'un besoin de reconditionnement.

Bien entendu, la présente invention n'est pas limitée aux exemples et aux modes de réalisation décrits et représentés, mais elle est susceptible de nombreuses variantes accessibles à l'homme de l'art.

## Revendications

1. Batterie (10) d'accumulateurs électrochimiques au nickel-cadmium comportant un indicateur de son état de charge (ÉTAT_{CHARGE}), ledit indicateur comprenant
- des capteurs (20 ; 30 ; 40) pour réaliser des mesures continues (110) de tension (U) et d'intensité (I) du courant électrique et de température (T) de ladite batterie,
- des moyens de détermination (120) à un instant t d'un historique (H_{T}) de charge/décharge de ladite batterie en fonction desdites mesures,
- des moyens de stockage de données dans lesquels sont mémorisés au moins un historique (H_{R}) de charge/décharge, une tension (U_{R}), une intensité (I_{R}) et une température (T_{R}) de référence prédéfinis, les mesures et l'historique déterminé (H_{T}),
- une unité de contrôle destinée à
- mesurer (130) une tension (U_{T}), une intensité (I_{T}) et une température (T_{T}) de ladite batterie à l'instant t,
- déterminer (145) un mode de fonctionnement (Ch; D; R) de ladite batterie par comparaison (140) de la tension (U_{T}) et de l'intensité (I_{T}) mesurées à l'instant t, vis-à-vis de la tension (U_{R}) et de l'intensité (I_{R}) de référence, respectivement,
- déterminer (155) une correction de la tension (U_{T}) et de l'intensité (I_{T}) mesurées à l'instant t par comparaison (135) de la température (T_{T}) mesurée à l'instant t, vis-à-vis de la température (T_{R}) de référence,
- calculer (150) une capacité théoriquement disponible (CT_{DISPO}) de ladite batterie en fonction du mode de fonctionnement (Ch; D; R) et de la correction, ainsi que de la tension (U_{T}) et de l'intensité (I_{T}) mesurées à l'instant t,
- déterminer (170) un besoin de recalage (R_{C}) de la capacité théoriquement disponible (CT_{DISPO}) de la batterie par comparaison (160) de l'historique (H_{T}) déterminé à l'instant t vis-à-vis de l'historique de référence (H_{R}),
- en fonction du besoin de recalage (R_{C}) et de la capacité théoriquement disponible, calculer (180) une capacité réellement disponible (CR_{DISPO}) de la batterie,
- en fonction de ladite capacité réellement disponible (CR_{DISPO}), définir (190) l'état de charge (ÉTAT_{CHARGE}) de ladite batterie,
- un dispositif (50) d'affichage (200) dudit état de charge défini.

2. Batterie (10) selon la revendication 1, **caractérisée en ce que** l'indicateur d'état de charge de ladite batterie est destiné à détecter une fin de charge de ladite batterie en fonction de l'historique déterminé (H_{T}) de ladite batterie, la détermination de la capacité théoriquement disponible (CT_{DISPO}) de ladite batterie étant réalisée après ladite détection de fin de charge.

3. Batterie (10) selon la revendication 1 ou 2, **caractérisée en ce que** l'historique de référence (H_{R}) et l'historique déterminé (H_{T}) comportent des données relatives
- à une température moyenne de la batterie (10), et/ou
- à la profondeur d'au moins une précédente décharge de ladite batterie, et/ou
- au temps qu'elle a passé en auto-décharge dans un mode de fonctionnement de repos (R) à circuit ouvert, et/ou
- au nombre de fois où elle a été chargée et/ou déchargée.

4. Batterie (10) selon l'une quelconque des revendications 1 à 3, **caractérisée en ce que**
- elle comporte en outre un circuit de remplissage d'eau,
- l'historique de référence (H_{R}) et l'historique déterminé (H_{T}) comportent des données relatives à la consommation d'eau de ladite batterie.

5. Batterie (10) selon l'une quelconque des revendications 1 à 4, **caractérisée en ce que** l'indicateur d'état de charge (ÉTAT_{CHARGE}) de ladite batterie est en outre destiné à
- calculer un taux de charge absolu (SOC_{ABS}) de ladite batterie en divisant la capacité réellement disponible (CR_{DISPO}) par une capacité nominale (C_{NOM}) prédéterminée de ladite batterie,
- définir l'état de charge de ladite batterie comme étant le taux de charge absolu (SOC_{ABS}).

6. Batterie (10) selon l'une quelconque des revendications 1 à 4, **caractérisée en ce que** l'indicateur d'état de charge (ÉTAT_{CHARGE}) de ladite batterie est en outre destiné à
- comparer une capacité minimale (C_{MIN}) nécessaire pour une utilisation future de ladite batterie à la capacité réellement disponible (CR_{DISPO}) de ladite batterie, ladite capacité minimale étant prédéfinie,
- définir l'état de charge (ÉTAT_{CHARGE}) de ladite batterie comme étant
- suffisant si ladite capacité réellement disponible (CR_{DISPO}) est strictement supérieure à ladite capacité minimale (C_{MIN}),
- insuffisant si ladite capacité réellement disponible (CR_{DISPO}) est inférieure ou égale à ladite capacité minimale (C_{MIN}).

7. Batterie (10) selon l'une quelconque des revendications 1 à 4, **caractérisée en ce que** l'indicateur d'état de charge (ÉTAT_{CHARGE}) de ladite batterie est en outre destiné à
- comparer un seuil (C_{SEUIL}) prédéfini de capacité réellement disponible de ladite batterie à la capacité réllement disponible (CR_{DISPO}) de ladite batterie,
- définir l'état de charge (ÉTAT_{CHARGE}) de ladite batterie comme étant
- suffisant si la capacité réellement disponible (CR_{DISPO}) est strictement supérieur audit seuil (C_{SEUIL}),
- insuffisant si la capacité réellement disponible (CR_{DISPO}) est inférieure ou égale audit seuil (C_{SEUIL}).

8. Batterie (10) selon l'une quelconque des revendications 1 à 4, **caractérisée en ce que** l'indicateur d'état de charge (ÉTAT_{CHARGE}) de ladite batterie est en outre destiné à
- déterminer une profondeur de décharge et un taux de décharge relatif (SOC_{DÉCHARGE}) de ladite batterie,
- comparer un seuil de taux de décharge relatif (SOC_{SEUIL}) prédéfini de ladite batterie audit taux de décharge relatif (SOC_{DÉCHARGE}),
- définir l'état de charge (ÉTAT_{CHARGE}) de ladite batterie comme étant
- suffisant si le taux de décharge relatif (SOC_{DÉCHARGE}) est strictement inférieur audit seuil (SOC_{SEUIL}),
- insuffisant si le taux de décharge relatif (SOC_{DÉCHARGE}) est supérieur ou égal audit seuil (SOC_{SEUIL}).

9. Batterie (10) selon l'une quelconque des revendications 1 à 8, **caractérisée en ce que** le dispositif d'affichage (50) de l'état de charge (ÉTAT_{CHARGE}) est
- soit binaire si ledit état de charge est défini comme étant suffisant ou insuffisant,
- soit gradué si ledit état de charge est défini comme étant un taux de charge absolu (SOC_{ABS}).

10. Batterie (10) selon l'une quelconque des revendications 1 à 9, **caractérisée en ce que**
- les moyens de mesure (20) de l'intensité (I) du courant électrique de ladite batterie comportent un shunt,
- les moyens de mesure (30) de la température (T) de ladite batterie comportent une thermistance de type CTN.

11. Système de gestion comportant
- au moins une batterie (10) selon l'une quelconque des revendications 1 à 9,
- un dipositif de contrôle distant de l'état de charge (ÉTAT_{CHARGE}) de l'au moins une batterie, l'indicateur d'état de charge de l'au moins une batterie étant connecté, via un dispositif de communication, audit dispositif de contrôle.

12. Procédé (100) d'indication d'un état de charge (ÉTAT_{CHARGE}) d'une batterie (10) d'accumulateurs électrochimiques au nickel-cadmium selon l'une quelconque des revendcations 1 à 10, ledit procédé comprenant des étapes de
- mesures continues (110) de tension (U) et d'intensité (I) du courant électrique et de température (T) de ladite batterie,
- détermination (120) à un instant t d'un historique (H_{T}) de charge/décharge de ladite batterie en fonction desdites mesures,
- mesure (130) d'une tension (U_{T}), d'une intensité (I_{T}) et d'une température (T_{T}) de ladite batterie à l'instant t,
- détermination (145) d'un mode de fonctionnement (Ch ; D ; R) de ladite batterie par comparaison (140) de la tension (U_{T}) et de l'intensité (I_{T}) mesurées à l'instant t, vis-à-vis de la tension (U_{R}) et de l'intensité (I_{R}) de référence, respectivement,
- détermination (155) d'une correction de la tension (U_{T}) et de l'intensité (I_{T}) mesurées à l'instant t par comparaison (135) de la température (T_{T}) mesurée à l'instant t, vis-à-vis de la température (T_{R}) de référence,
- calcul (150) d'une capacité théoriquement disponible (CT_{DISPO}) de ladite batterie en fonction du mode de fonctionnement (Ch; D; R) et de ladite correction,
- détermination (170) d'un besoin de recalage (R_{C}) de la capacité théoriquement disponible (CT_{DISPO}) de la batterie par comparaison (160) de l'historique (H_{T}) déterminé à l'instant t vis-à-vis de l'historique de référence (H_{R}),
- en fonction dudit besoin de recalage (R_{C}) et de ladite capacité théoriquement disponible, calcul (180) d'une capacité réellement disponible (CR_{DISPO}) de ladite batterie,
- en fonction de ladite capacité réellement disponible (CR_{DISPO}) de ladite batterie, définition (190) de l'état état de charge (ÉTAT_{CHARGE}) de ladite batterie,
- affichage (200) dudit état de charge défini.

## Patentansprüche

1. Batterie (10) aus elektrochemischen Nickel-Cadmium-Akkumulatoren, umfassend eine Anzeige ihres Ladungszustands (ÉTAT_{CHARGE}), wobei die Anzeige aufweist
- Sensoren (20; 30; 40), um kontinuierliche Messungen (110) der Spannung (U) und der Stärke (I) des elektrischen Stroms und der Temperatur (T) der Batterie durchzuführen,
- Mittel zum Bestimmen (120) einer Lade- und Entladehistorie (H_{T}) der Batterie zu einem Zeitpunkt t in Abhängigkeit von den Messungen,
- Datenspeichermittel, in denen mindestens eine vorgegebene Referenz-Lade- und Entladehistorie (H_{R}), eine vorgegebene Referenzspannung (U_{R}), eine vorgegebene Referenzstromstärke (I_{R}) und eine vorgegebene Referenztemperatur (T_{R}), die Messungen und die bestimmte Historie (H_{T}) gespeichert sind, eine Steuereinheit, die dazu bestimmt ist,
- eine Spannung (U_{T}), eine Stromstärke (I_{T}) und eine Temperatur (T_{T}) der Batterie zu dem Zeitpunkt t zu messen (130),
- einen Betriebsmodus (Ch; D; R) der Batterie durch Vergleichen (140) der Spannung (U_{T}) und der Stromstärke (I_{T}), die zu dem Zeitpunkt t gemessen werden, jeweils mit der Referenzspannung (U_{R}) und der Referenzstromstärke (I_{R}) zu bestimmen (145),
- eine Korrektur der Spannung (U_{T}) und der Stromstärke (I_{T}), die zu dem Zeitpunkt t gemessen werden, durch Vergleichen (135) der Temperatur (T_{T}), die zu dem Zeitpunkt t gemessen wird, mit der Referenztemperatur (T_{R}) zu bestimmen (155),
- eine theoretisch verfügbare Kapazität (CT_{DISPO}) der Batterie in Abhängigkeit von dem Betriebsmodus (Ch; D; R) und der Korrektur und der Spannung (U_{T}) und der Stromstärke (I_{T}), die zu dem Zeitpunkt t gemessen werden, zu berechnen (150),
- eine Notwendigkeit des Neueinstellens (R_{C}) der theoretisch verfügbaren Kapazität (CT_{DISPO}) der Batterie durch Vergleichen (160) der Historie (H_{T}), die zu dem Zeitpunkt t bestimmt wird, mit der Referenzhistorie (H_{R}) zu bestimmen (170),
- in Abhängigkeit von der Notwendigkeit des Neueinstellens (Rc) und der theoretisch verfügbaren Kapazität eine tatsächlich verfügbare Kapazität (CR_{DISPO}) der Batterie zu berechnen (180),
- in Abhängigkeit von der tatsächlich verfügbaren Kapazität (CR_{DISPO}) den Ladungszustand (ÉTAT_{CHARGE}) der Batterie zu definieren (190),
- eine Vorrichtung (50) zum Anzeigen (200) des definierten Ladungszustands.

2. Batterie (10) nach Anspruch 1, **dadurch gekennzeichnet, dass** die Ladungszustandsanzeige der Batterie dazu bestimmt ist, ein Ladungsende der Batterie in Abhängigkeit von der bestimmten Ladehistorie (H_{T}) zu erfassen, wobei das Bestimmen der theoretisch verfügbaren Kapazität (CT_{DISPO}) der Batterie nach dem Erfassen des Ladungsendes durchgeführt wird.

3. Batterie (10) nach Anspruch 1 oder 2, **dadurch gekennzeichnet, dass** die Referenzhistorie (H_{R}) und die bestimmte Ladehistorie (H_{T}) Daten aufweisen, die bezogen sind auf
- eine durchschnittliche Temperatur der Batterie (10) und/oder
- eine Tiefe mindestens einer vorhergehenden Entladung der Batterie (10) und/oder
- die Zeit, die sie in Selbstentladung in einem Ruhebetriebsmodus (R) im offenen Schaltungszustand verbracht hat, und/oder
- die Anzahl der Male, die sie geladen und/oder entladen worden ist.

4. Batterie (10) nach einem der Ansprüche 1 bis 3, **dadurch gekennzeichnet, dass**
- sie ferner einen Wassernachfüllzyklus aufweist,
- die Referenzhistorie (H_{R}) und die bestimmte Ladehistorie (H_{T}) Daten in Bezug auf den Wasserverbrauch der Batterie aufweisen.

5. Batterie (10) nach einem der Ansprüche 1 bis 4, **dadurch gekennzeichnet, dass** die Ladungszustandsanzeige (ÉTAT_{CHARGE}) der Batterie ferner dazu bestimmt ist,
- eine absolute Laderate (SOC_{ABS}) der Batterie durch Dividieren der tatsächlich verfügbaren Kapazität (CR_{DISPO}) durch eine vorbestimmte Nennkapazität (C_{NOM}) der Batterie zu berechnen,
- den Ladungszustand der Batterie als die absolute Laderate (SOC_{ABS}) zu definieren .

6. Batterie (10) nach einem der Ansprüche 1 bis 4, **dadurch gekennzeichnet, dass** die Ladungszustandsanzeige (ÉTAT_{CHARGE}) der Batterie ferner dazu bestimmt ist,
- eine Mindestkapazität (C_{MIN}), die für eine zukünftige Verwendung der Batterie notwendig ist, mit der tatsächlich verfügbaren Kapazität (CR_{DISPO}) der Batterie zu vergleichen, wobei die Mindestkapazität vorgegeben ist,
- den Ladungszustand (ÉTAT_{CHARGE}) der Batterie zu definieren als
- ausreichend, wenn die tatsächlich verfügbare Kapazität (CR_{DISPO}) deutlich größer als die Mindestkapazität (C_{MIN}) ist,
- nicht ausreichend, wenn die tatsächlich verfügbare Kapazität (CR_{DISPO}) kleiner oder gleich der Mindestkapazität (C_{MIN}) ist.

7. Batterie (10) nach einem der Ansprüche 1 bis 4, **dadurch gekennzeichnet, dass** die Ladungszustandsanzeige (ÉTAT_{CHARGE}) der Batterie ferner dazu bestimmt ist,
- einen vorgegebenen Schwellwert (C_{SEUIL}) der tatsächlich verfügbaren Kapazität der Batterie mit der tatsächlich verfügbaren Kapazität (CR_{DISPO}) der Batterie zu vergleichen,
- den Ladungszustand (ÉTAT_{CHARGE}) der Batterie zu definieren als
- ausreichend, wenn die tatsächlich verfügbare Kapazität (CR_{DISPO}) deutlich größer als der Schwellwert (C_{SEUIL}) ist,
- nicht ausreichend, wenn die tatsächlich verfügbare Kapazität (CR_{DISPO}) kleiner oder gleich dem Schwellwert (C_{SEUIL}) ist.

8. Batterie (10) nach einem der Ansprüche 1 bis 4, **dadurch gekennzeichnet, dass** die Ladungszustandsanzeige (ÉTAT_{CHARGE}) der Batterie ferner dazu bestimmt ist,
- eine Entladungstiefe und eine relative Entladerate (SOC_{DÉCHARGE}) der Batterie zu bestimmen,
- einen vorgegebenen Schwellenwert der relativen Entladerate (SOC_{SEUIL}) der Batterie mit der relativen Entladerate (SOC_{DÉCHARGE}) zu vergleichen,
- den Ladungszustand (ÉTAT_{CHARGE}) der Batterie zu definieren als
- ausreichend, wenn die relative Entladerate (SOC_{DÉCHARGE}) deutlich größer als der Schwellwert (SOC_{SEUIL}) ist,
- nicht ausreichend, wenn die relative Entladerate (SOC_{DÉCHARGE}) kleiner oder gleich dem Schwellwert (SOC_{SEUIL}) ist.

9. Batterie (10) nach einem der Ansprüche 1 bis 8, **dadurch gekennzeichnet, dass** Vorrichtung zum Anzeigen (50) des Ladungszustands (ÉTAT_{CHARGE})
- entweder binär ist, wenn der Ladungszustand als ausreichend oder nicht ausreichend definiert ist,
- oder skaliert ist, wenn der Ladungszustand als eine absolute Laderate (SOC_{ABS}) definiert ist.

10. Batterie (10) nach einem der Ansprüche 1 bis 9, **dadurch gekennzeichnet, dass**
- die Mittel zum Messen (20) der Stärke (I) des elektrischen Stroms der Batterie einen Shunt aufweisen,
- die Mittel zum Messen (30) der Temperatur (T) der Batterie einen Thermistor vom Typ des NTC-Thermistors aufweisen.

11. Verwaltungssystem, umfassend
- mindestens eine Batterie (10) nach einem der Ansprüche 1 bis 9,
- eine Fernsteuervorrichtung des Ladungszustands (ÉTAT_{CHARGE}) der mindestens einen Batterie, wobei die Ladungszustandsanzeige der mindestens einen Batterie über eine Kommunikationsvorrichtung mit der Steuervorrichtung verbunden ist.

12. Verfahren (100) zum Anzeigen eines Ladungszustands (ÉTAT_{CHARGE}) einer Batterie (10) aus elektrochemischen Nickel-Cadmium-Akkumulatoren nach einem der Ansprüche 1 bis 10, wobei das Verfahren die Schritte aufweist
- der kontinuierliche Messungen (110) der Spannung (U) und der Stärke (I) des elektrischen Stroms und der Temperatur (T) der Batterie,
- des Bestimmens (120) einer Lade- und Entladehistorie (H_{T}) der Batterie zu einem Zeitpunkt t in Abhängigkeit von den Messungen,
- des Messens (130) einer Spannung (U_{T}), einer Stromstärke (I_{T}) und einer Temperatur (T_{T}) der Batterie zu dem Zeitpunkt t,
- des Bestimmens (145) eines Betriebsmodus (Ch; D; R) der Batterie durch Vergleichen (140) der Spannung (U_{T}) und der Stromstärke (I_{T}), die zu dem Zeitpunkt t gemessen werden, jeweils mit der Referenzspannung (U_{R}) und der Referenzstromstärke (I_{R}),
- des Bestimmens (155) einer Korrektur der Spannung (U_{T}) und der Stromstärke (I_{T}), die zu dem Zeitpunkt t gemessen werden, durch Vergleichen (135) der Temperatur (T_{T}), die zu dem Zeitpunkt t gemessen wird, mit der Referenztemperatur (T_{R}),
- des Berechnens (150) einer theoretisch verfügbaren Kapazität (CT_{DISPO}) der Batterie in Abhängigkeit von dem Betriebsmodus (Ch; D; R) und der Korrektur,
- des Bestimmens (170) einer Notwendigkeit des Neueinstellens (Rc) der theoretisch verfügbaren Kapazität (CT_{DISPO}) der Batterie durch Vergleichen (160) der Historie (H_{T}), die zu dem Zeitpunkt t bestimmt wird, mit der Referenzhistorie (H_{R}),
- des Berechnens (180) von einer tatsächlich verfügbaren Kapazität (CR_{DISPO}) der Batterie in Abhängigkeit von der Notwendigkeit des Neueinstellens (Rc) und der theoretisch verfügbaren Kapazität,
- des Definieren (190) des Ladungszustands (ÉTAT_{CHARGE}) der Batterie in Abhängigkeit von der tatsächlich verfügbaren Kapazität (CR_{DISPO}),
- des Anzeigens (200) des definierten Ladungszustands.

## Claims

1. A battery (10) made up of nickel-cadmium electrochemical storage cells including an indicator of a state of charge (SOC), the indicator comprising
- sensors (20; 30; 40) for performing continuous measurements (110) of voltage (U) and current (I) and of temperature (T) of said battery,
- means for determining (120) at a time t, a history (H_{T}) for charge/discharge of said battery based on said measurements
- data storage means in which there are stored at least a history (H_{R}) of charge/discharge, a predefined reference voltage (U_{R}), current (I_{R}) and temperature (T_{R}), and the measurements and history determined (H_{T})
- a control unit for
- measuring (130) a voltage (U_{T}), a current (I_{T}) and a temperature (T_{T}) of said battery at a time t,
- determining (145) an operation mode (Ch; D; R) of said battery by comparing (140) the voltage (U_{T}) and current (I_{T}) measured at a time t, with respectively a reference voltage (UR) and reference current (I_{R}),
- determining (155) a correction to be applied to the voltage (U_{T}) and current (I_{T}) measured at time t by comparing (135) the temperature (T_{T}) measured at time t, with a reference temperature (T_{R}),
- calculating (150) a theoretically available capacity (CT_{AVAIL}) of said battery depending on the operating mode (Ch, D, R) and the correction, as well as a voltage (U_{T}) and a current (I_{T}) measured at time t,
- determining (170) a need for recalibration (R_{C}) of the theoretically available capacity (CT_{AVAIL}) of the battery by comparing (160) said history (H_{T}) determined at time t to the reference history (H_{R}),
- depending on the need for recalibration (R_{C}) and the theoretically available capacity, calculating (180) a capacity actually available (CR_{AVAIL}) of said battery,
- based on said capacity actually available (CR_{AVAIL}), defining (190) the state of charge (SOC) of said battery,
- a device (50) for displaying (200) said defined state of charge.

2. The battery (10) according to claim 1, **characterized in that** the said battery state of charge indicator is adapted for detecting an end of charge of said battery based on the determined history (H_{T}) of said battery, determination of the theoretically available capacity (CT_{AVAIL}) of said battery being performed after said end of charge detection.

3. The battery (10) according to claim 1 or 2, **characterized in that** said reference history (H_{R}) and said determined history (H_{T}) comprise data relating to:
- an average temperature of the battery (10), and/or
- a depth of at least one previous discharge of said battery, and/or
- a time the battery has spent in self-discharge in a resting mode (R) in open circuit, and/or
- a number of times the battery has been charged and/or discharged.

4. The battery (10) according to any one of claims 1 to 3, **characterized in that**
- it further comprises a water filling circuit,
- the reference history (H_{R}) and the determined history (H_{T}) comprise data related to the water consumption of said battery.

5. The battery (10) according to any one of claims 1 to 4, **characterized in that** the state of charge (SOC) indicator of said battery is additionally adapted to:
- calculate an absolute state of charge (SOC_{ABS}) for said battery obtained by dividing the actually available capacity (CR_{AVAIL}) by a predetermined nominal capacity (C_{NOM}) of said battery,
- define a state of charge of said battery as being said absolute state of charge (SOC_{ABS}).

6. The battery (10) according to any one of claims 1 to 4, **characterized in that** the state of charge indicator (SOC) of said battery is additionally adapted to:
- compare a minimum capacity (C_{MIN}) necessary for future use of said battery to the actually available capacity (CR_{AVAIL}) of said battery, said minimum capacity being predefined,
- define a state of charge (SOC) of said battery to be
- sufficient if said capacity actually available (CR_{AVAIL}) is strictly greater than said minimum capacity (C_{MIN})
- insufficient if said actually available capacity (CR_{AVAIL}) is less than or equal to said minimum capacity (C_{MIN}).

7. The battery (10) according to any one of claims 1 to 4, **characterized in that** the state of charge (SOC) indicator of said battery is additionally adapted to
- compare a predetermined threshold (C_{THOLD}) for capacity actually available of said battery to the capacity actually available (CR_{AVAIL}) of said battery,
- define a state of charge (SOC) of said battery as being
- sufficient if the actually available capacity (CR_{AVAIL}) is strictly greater than said threshold (C_{THOLD})
- insufficient if the actually available capacity (CR_{AVAIL}) is less than or equal to said threshold (C_{THOLD}).

8. The battery (10) according to any one of claims 1 to 4, **characterized in that** the state of charge (SOC) indicator of said battery is additionally adapted to
- determine a depth of discharge and relative degree of discharge (SOC_{DISCH}) of said battery,
- compare a predetermined relative degree of discharge threshold (SOC_{THOLD}) of said battery to said relative degree of discharge (SOC_{DISCH})
- define the state of charge (SOC) of said battery as being
- sufficient if the relative degree of discharge (SOC_{DISCH}) is strictly lower than the threshold (SOC_{THOLD})
- insufficient if the relative degree of discharge (SOC_{DISCH}) is greater than or equal to said threshold (SOC_{THOLD}).

9. The battery (10) according to any one of claims 1 to 8, **characterized in that** the display device (50) for state of charge (SOC) is
- either binary if said state of charge is defined as sufficient or insufficient,
- or graduated if said state of charge is defined as an absolute state of charge (SOC_{ABS}).

10. The battery (10) according to any one of claims 1 to 9, **characterized in that**
- a measuring means (20) for current (I) of said battery comprises a shunt,
- a measuring means (30) for temperature (T) of said battery comprises an NTC thermistor.

11. A management system comprising
- at least one battery (10) according to any one of claims 1 to 9,
- a remote control device for state of charge (SOC) of the at least one battery, the state of charge indicator of the at least one battery being connected via communication means to said control device.

12. A method (100) for indicating a state of charge (SOC) of a battery (10) made up of nickel-cadmium electrochemical cells according to any one of claims 1 to 10, said method comprising the steps of
- continuously measuring (110) voltage (U) and current (I) and temperature (T) of the battery (10),
- determining (120) a charge/discharge history (H_{T}) of the battery (10) at time t based on the measurements,
- measuring (130) a voltage (U_{T}), a current (I_{T}) and a temperature (T_{T}) of the battery at time t,
- determining (145) a charging, (Ch), discharging, (D), or resting, (R), mode of the battery by comparing (140) a voltage (U_{T}) and a current (I_{T}) measured at time t, with respect to a reference voltage (U_{R}) and a reference current (I_{R}), respectively,
- determining a correction to be applied to voltage (U_{T}) and current (I_{T}) measured at time t by comparing a temperature (T_{T}) measured at time t, when compared to a reference temperature (T_{R}),
- calculating (150) a theoretically available capacity (CT_{AVAIL}) of the battery depending on whether the operating mode is charging (Ch), discharging (D) or resting (R) mode as determined, and the said correction,
- determining (170) a need for recalibration (R_{C}) of the theoretically available capacity (CT_{AVAIL}) of the battery by comparing (160) the history (H_{T}) determined at time t with the reference history (H_{R}),
- depending on the need for recalibration (R_{C}) and the theoretically available capacity, calculating (180) the actually available capacity (CR_{AVAIL}) of the battery (10),
- depending on the actually available capacity (CR_{AVAIL}) of the battery, defining (190) a state of charge (SOC) of the battery,
- displaying (200) the defined state of charge.
